Europäisches Patentamt

European Patent Office

Office européen des brevets

(11) Publication number: **0 647 030 A2**

# EUROPEAN PATENT APPLICATION

(21) Application number: **94115120.1**

(22) Date of filing: **26.09.94**

(51) Int. Cl.⁶: **H03K 19/173**, H03K 19/21

(30) Priority: **30.09.93 US 129881**

(43) Date of publication of application:
**05.04.95 Bulletin 95/14**

(84) Designated Contracting States:
**DE FR GB IT NL**

(71) Applicant: **TEXAS INSTRUMENTS
INCORPORATED
13500 North Central Expressway
Dallas
Texas 75265 (US)**

(72) Inventor: **Mahant-Shetti, Shivaling S.**
**1405 Scottsboro Lane**
**Richardson, TX 75082 (US)**
Inventor: **Landers, Robert J.**
**3228 Cross Bend**
**Plano,**
**Texas 75023 (US)**

(74) Representative: **Schwepfinger, Karl-Heinz,**
**Dipl.-Ing. et al**
**Prinz & Partner,**
**Manzingerweg 7**
**D-81241 München (DE)**

(54) **Integrated circuit devices.**

(57) A base cell device (10) includes a first transmission gate (12) configured as a multiplexer comprising an N-channel transistor (14) and a P-channel transistor (16). The base cell device (10) also includes a second transmission gate (18) configured as a multiplexer that comprises an N-channel transistor (20) and a P-channel transistor (22). The first transmission gate (12) and the second transmission gate (18) each receive a control signal C and an inverted control signal from an inverter (24). The first transmission gate (12) receives a first input signal (A) and the second transmission gate (18) receives a second input signal (B). The base cell device (10) generates a common output signal (O) from the first transmission gate (12) and the second transmission gate (18). The base cell device (10) is capable of performing all two input function operations.

FIG. 1

$$O = C \cdot A + \overline{C} \cdot B$$

TECHNICAL FIELD OF THE INVENTION

The present invention relates in general to integrated circuit devices and more particularly to a base cell device for providing all two input functions.

BACKGROUND OF THE INVENTION

In metal programmable gate arrays, it is desirable to be able to generate all combinations of N-variables. Base cells are used to create such gate arrays. Traditional layouts of base cells have used a combination of two P-channel and two N-channel transistors. The gates of the two P-channel transistors are typically connected to their respective N-channel counterpart transistors. The possible functions of the traditional base cell, obtained by connection of metal and contact, are NAND, NOR, NOT, and buffered output operations. However, the traditional base cell cannot conveniently perform other types of functions such as AND, OR, XOR, or XNOR operations without using multiple traditional base cells or requiring multiple logic stages.

Further, in order to achieve higher density and lower power, smaller transistors are desired to generate the logic while maintaining output drive through larger devices. However, traditional base cells require a minimum of three metal track connections for the n-channel and p-channel transistors in order to provide logic operation and transmission gates. The required connections in a traditional base cell limit the ability to reduce the size of transistors for logic operations. Therefore, it is desirable to have a base cell device that can perform a variety of two input functions with smaller and fewer transistors at a reduced power consumption than in a traditional base cell.

SUMMARY OF THE INVENTION

From the foregoing it may be appreciated that a need has arisen for a base cell device that can perform a wide variety of two input functions. A need has also arisen for a base cell device with reduced transistor size and reduced power consumption capabilities for performing two input functions.

In accordance with the present invention, a base cell device for generating two input functions is provided which substantially eliminates or reduces disadvantages and problems associated with traditional base cell approaches.

According to an embodiment of the present invention, there is provided a device for generating two input functions that includes an inverter for receiving a control signal and generating an inverted control signal in response thereof. A first transmission gate receives a first input, the control signal, and the inverted control signal. A second transmission gate receives a second input, the control signal, and the inverted control signal. The first and second transmission gates produce a single output that provides a result according to the function desired to be performed.

The device of the present invention provides various technical advantages over traditional base cell approaches. For example, one technical advantage is in performing a greater number of two input functions than that of the traditional base cell. Another technical advantage is in employing a multiplexer design to a base cell device. Yet another technical advantage is in using the multiplexer base cell device for higher order input functions. Still another technical advantage is in providing a base cell device with fewer transistors, smaller transistor sizes, and reduced power consumption as compared to traditional base cells in performing function generation. Other technical advantages are readily apparent to one skilled in the art from the following figures, descriptions, and claims.

Various aspects of the invention are defined in the claims.

BRIEF DESCRIPTION OF THE DRAWINGS

For a more complete understanding of the present invention and the advantages thereof, reference is now made to the following description taken in conjunction with the accompanying drawings, wherein like reference numerals represent like parts, in which:

FIGURE 1 illustrates a simplified schematic diagram of a multiplexer base cell device;

FIGUREs 2A-B illustrate simplified schematic diagrams of the multiplexer base cell device performing NAND and NOR functions;

FIGUREs 3A-B illustrate simplified schematic diagrams of the multiplexer base cell device performing XNOR and XOR functions;

2

FIGURE 4 illustrates a simplified schematic diagram of a four input NAND function employing multiplexer base cell devices; and

FIGURE 5 illustrates a simplified schematic diagram of a layout for the multiplexer base cell device.

DETAILED DESCRIPTION OF THE INVENTION

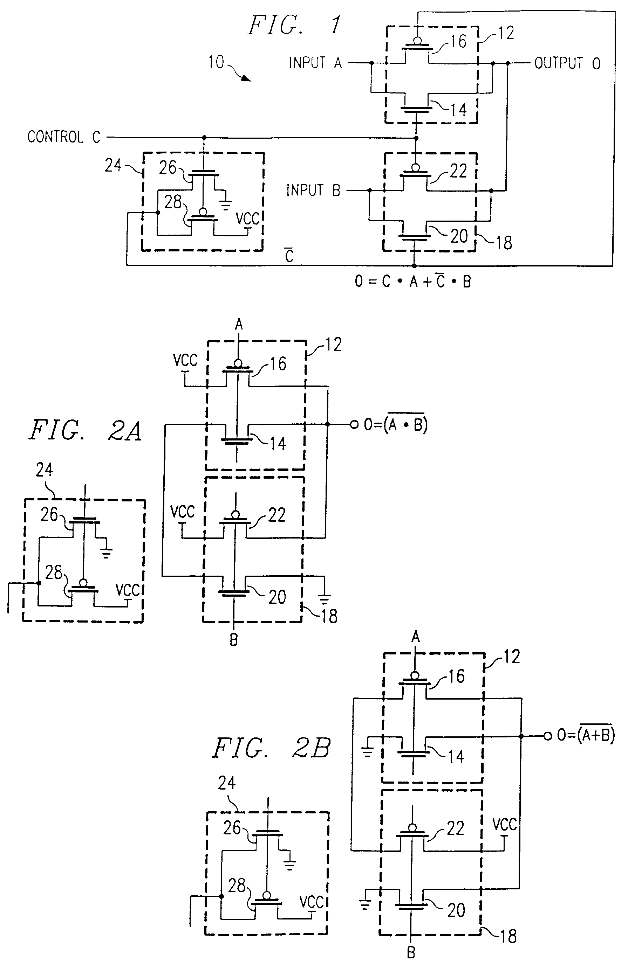

FIGURE 1 is a schematic layout of a multiplexer (MUX) base cell device 10. MUX base cell device 10 includes a first transmission gate 12 comprised of N-channel transistor 14 and P-channel transistor 16 configured into a first multiplexer layout. MUX base cell device 10 also includes a second transmission gate 18 comprised of N-channel transistor 20 and P-channel transistor 22 configured into a second multiplexer layout. MUX base cell device 10 receives a control signal C that is applied to the gates of N-channel transistor 14 of first transmission gate 12 and P-channel transistor 22 of second transmission gate 18. MUX base cell device 10 also generates an inverted control signal through an inverter 24, comprising N-channel transistor 26 and P-channel transistor 28, and the inverted control signal is applied to the gates of N-channel transistor 20 of second transmission gate 18 and P-channel transistor 16 of first transmission gate 12. MUX base cell device 10 also receives a first input signal A at the sources of N-channel transistor 14 and P-channel transistor 16 of first transmission gate 12. MUX base cell device 10 also receives a second input signal B at the sources of N-channel transistor 20 and P-channel transistor 22 of second transmission gate 18. MUX base cell device 10 generates an output signal O at the drains of N-channel transistors 14 and 20 and P-channel transistors 16 and 22.

In operation, MUX base cell device 10 is configured to provide results according to the following equation:

$$O = C \cdot A + \overline{C} \cdot B \qquad (1)$$

From equation 1, control signal C is AND'ed with first input signal A, $\overline{C}$ inverted control signal $\overline{C}$ is AND'ed with second input signal B, and the results of the two AND functions are OR'ed together to produce output signal O. From this equation of base cell device 10, a variety of possible combinations of two input functions can be derived.

For two inputs, four possible AND combinations exist, namely $X \cdot Y$, $X \cdot \overline{Y}, \overline{X} \cdot Y, \cdot Y$, and $\overline{X} \cdot \overline{Y}$ . Table I illustrates how the four possible AND combinations can be used as literals in deriving all possible combinations of two input functions.

3

TABLE I

| | $X \bullet Y$ | $X \bullet \overline{Y}$ | $\overline{X} \bullet Y$ | $\overline{X} \bullet \overline{Y}$ | |
|---|---|---|---|---|---|
| 0 | 0 | 0 | 0 | 0 | 0 |
| 1 | 0 | 0 | 0 | 1 | $\overline{X} . \overline{Y} = (\overline{X+Y}) = (X\ NOR\ Y)$ |
| 2 | 0 | 0 | 1 | 0 | $\overline{X} . Y$ |
| 3 | 0 | 0 | 1 | 1 | $\overline{X} Y + \overline{X}\ \overline{Y} = \overline{X}$ |
| 4 | 0 | 1 | 0 | 0 | $X \bullet \overline{Y}$ |
| 5 | 0 | 1 | 0 | 1 | $X \bullet \overline{Y} + \overline{X} \bullet \overline{Y} = \overline{Y}$ |
| 6 | 0 | 1 | 1 | 0 | $X \bullet \overline{Y} + \overline{X} \bullet Y = (X\ XOR\ Y)$ |
| 7 | 0 | 1 | 1 | 1 | $(\overline{X \bullet Y}) = (X\ XNOR\ Y)$ |
| 8 | 1 | 0 | 0 | 0 | $X \bullet Y = (X\ AND\ Y)$ |
| 9 | 1 | 0 | 0 | 1 | $X \bullet Y + \overline{X} \bullet \overline{Y} = (X\ XNOR\ Y)$ |
| 10 | 1 | 0 | 1 | 0 | $X \bullet Y + \overline{X} \bullet Y = Y$ |
| 11 | 1 | 0 | 1 | 1 | $(\overline{X \bullet \overline{Y}}) = \overline{X} + Y$ |
| 12 | 1 | 1 | 0 | 0 | $X \bullet Y + X \bullet \overline{Y} = X$ |
| 13 | 1 | 1 | 0 | 1 | $(\overline{\overline{X} \bullet Y}) = X + \overline{Y}$ |
| 14 | 1 | 1 | 1 | 0 | $(\overline{\overline{X} \bullet \overline{Y}}) = X + Y = (X\ OR\ Y)$ |
| 15 | 1 | 1 | 1 | 1 | 1 |

Lines 2 and 4 of Table I can be combined into a generic AND function with one input inverted. Similarly, lines 11 and 13 of Table I can be combined as a generic OR function with one input inverted. After combining lines, Table I shows that the type of functions required for two inputs becomes X NOR Y, X NAND Y, X XOR Y, X XNOR Y, X AND Y, X OR Y, X AND$^{\overline{Y}}$, and X OR$^{\overline{Y}}$. Of these eight two input functions, the traditional base cell device, which typically implements a NAND logic function, is capable of only performing two of these operations, the NAND and NOR functions.

MUX base cell device 10 can be used to perform a variety of the functions identified above by changing input level states and altering connections of metal and contact. Referring to equation 1, the results depicted in Table I, and Boolean identities, an AND function (C • A) is generated by setting B equal to 0. An inverted input AND function ($\overline{C}$ X B) can be generated by setting A equal to 0. An OR function ([C + $\overline{C}$ B] = C + B) can be generated by setting A equal to 1. An inverted input OR function ([C• A + $\overline{C}$] = A + $\overline{C}$) can be generated by setting B equal to 1.

The output of MUX base cell device 10 can be used to control gate current for driver transistors in larger circuit applications. By performing the logic functions at the gate of a driver, smaller devices can be used in MUX base cell device 10 to perform more logic functions at low power than in a traditional base cell. Function generation can occur through smaller current requirements with larger drivers providing an appropriate current level for circuit drive. In this manner, logic functions can be performed more efficiently with lesser power requirements than in a traditional base cell device. Further, MUX base cell device 10 can provide an output either in-phase or out of phase with the inputs whereas a traditional base cell needs an extra inverter to provide an output signal in-phase (i.e., no inversions) with the input signals, resulting in increased delay in the device.

FIGUREs 2A-B depict how MUX base dell device 10 can be configured to perform NAND and NOR functions. By not using inverter 24, MUX base cell device 10 can be configured as a traditional base cell to perform the NAND and NOR functions. The NAND function configuration is shown in FIGURE 2A and FIGURE 2B depicts the NOR function configuration.

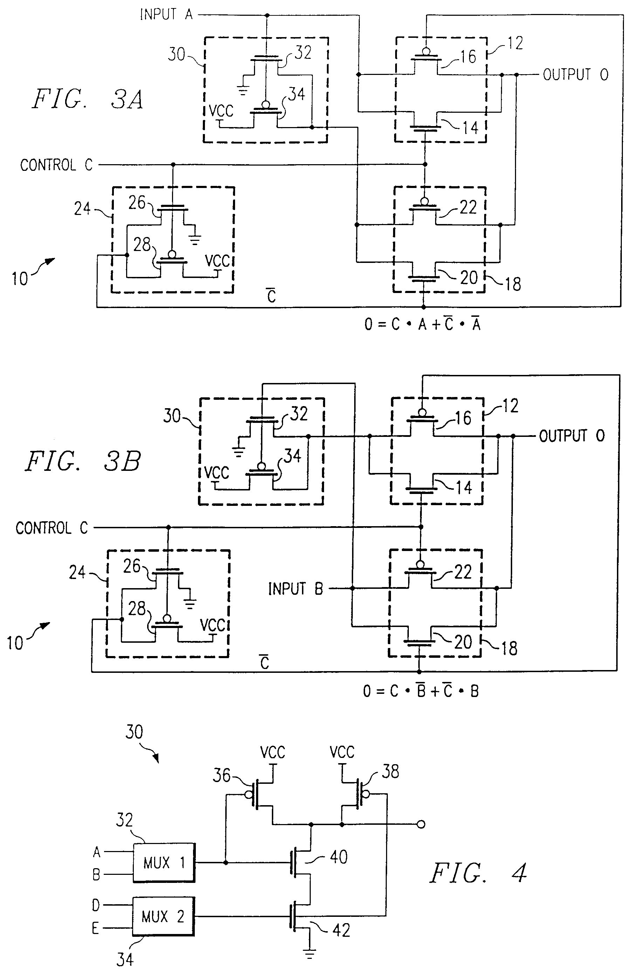

FIGUREs 3A-B depict how an additional inverter inserted into MUX base cell device 10 can perform additional two input functions. By using additional inverter 30 comprising N-channel transistor 32 and P-channel transistor 34, FIGURE 3A shows how an XNOR function (C A + $\overline{C}$ $\overline{A}$) can be generated by setting

4

B equal to $\overline{A}$. Further, the additional inverter 26 can produce an XOR function (C $\overline{B}$ + $\overline{C}$ •B) by setting A equal to $\overline{B}$ as shown in FIGURE 3B. MUX base cell device 10 of FIGURE 1 may be identical to that shown in FIGUREs 3A or 3B with inverter 26 unconnected.

As previously described, MUX base cell device 10 can generate an AND function and an OR function and an inverted input AND function and an inverted input OR function. Recognizing that a NOR function is an AND function with both inputs inverted and a NAND function is an OR function with both inputs inverted, MUX base cell device 10 is capable of generating an AND function and an OR function with none, one, or both inputs inverted. This property is very useful in higher order input extensions of the circuit.

For example, a four input NAND gate can be formed by two MUX base cell device 10, each configured into an AND function. FIGURE 4 depicts a four input NAND configuration. A four input device 30 includes a first MUX base cell 32, receiving inputs A and B, and a second MUX base cell 34, receiving inputs D and E. Four input device 30 also includes N-channel drivers 36 and 38 in series and P-channel drivers 40 and 42 in parallel. Driver transistors 36, 38, 40, and 42 are configured into a traditional base cell NAND function to create the overall four input NAND. The two MUX base cell devices 32 and 34 are each configured into an AND function and can each have none, one, or two inputs inverted as previously described to provide a totally flexible NAND operation with as many of the four inputs inverted as desired. A four input NOR function can also be generated in a similar manner. Extension of MUX base cell device applications to additional inputs can easily be performed by adding MUX base cell devices and driver transistors.

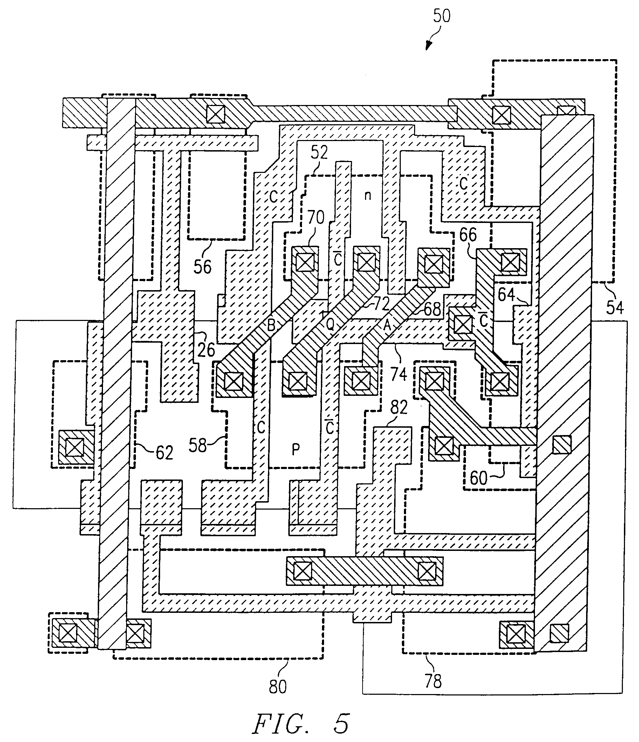

FIGURE 5 is a simplified schematic diagram of a layout 50 for the multiplexer base cell device 10. Layout 50 includes N-channel transistor blocks 52, 54, and 56 and P-channel transistor blocks 58, 60, and 62. N-channel transistor block 54 and P-channel transistor block 60 provide transistors 26 and 28 respectively for inverter 24. Control signal C gate connection 64 generates inverted control signal $\overline{C}$ at a connection 66. N-channel transistor block 52 and p-channel transistor block 54 provide n-channel transistors 14 and 20 and p-channel transistors 16 and 22 where input signal A connection 68 and input signal B connection 70 are connected and as shown in FIGURE 1. An output signal O connection 72 generates the output for multiplexer base cell device 10. Control signal C gate connection 64, and an inverted control signal $\overline{C}$ gate connection 74 from connection 66, provide the gate signals for the appropriate n-channel and p-channel transistors. N-channel transistor block 56 and p-channel transistor block 62 provide the additional inverter for XOR and XNOR operations when gate connection 76 is connected to the appropriate input signal. An n-channel transistor block 78 and a p-channel transistor block 80 provide the large driver transistors when connection is made to driver gate connection 82.

Layout 50 of FIGURE 5 overcomes the size limitations of transistors within traditional base cells by avoiding the necessity of three metal track connections for the transistors. No twisting or overlapping of metal connections occurs in layout 50 as found in traditional base cells. The gate connections 64 and 74 of control signal C and inverted control signal $\overline{C}$ provide the twisting such that multiplexer base cell device 10 lays out more efficiently than traditional base cells. The minimum size of the transistors is made consistent with a single metal track connection, thus reducing the area and size of the transistors for the function generation as compared to traditional base cells. Larger size transistors can be saved and used for appropriate drive requirements.

In summary, a base cell device includes two transmission gates each made up of an N-channel and a P-channel transistor. Each transmission gate receives a control signal and an inverted control signal and separate input signals. The base cell device generates a common output from the two transmission gates for performing a variety of two input function generation.

Thus, it is apparent that there has been provided, in accordance with the present invention, a base cell device for providing all two input functions that satisfies the advantages set forth above. Although the preferred embodiment has been described in detail, it should be understood that various changes, substitutions, and alterations can be made herein. For example, many of the direct connections illustrated herein could be altered by one skilled in the art such that two components are merely coupled to one another through an intermediate component or components without being directly connected as illustrated herein. Other examples are readily ascertainable by one skilled in the art and could be made without departing from the spirit and scope of the present invention as defined by the following claims.

**Claims**

1. A device for providing two input functions, comprising:
    an inverter for receiving a control signal and generating an inverted control signal in response thereof;
    a first input circuitry for receiving a first input; and
    a second input circuitry for receiving a second input, said first and second circuitry producing a single output.

2. The device of claim 1, wherein said first input circuit, said second input circuit and said inverter each include an N-channel transistor and a P-channel transistor.

3. The device of claim 2, wherein said first input connects to sources of said N-channel and P-channel transistors of said first input circuit, said second input connecting to sources of said N-channel and P-channel transistors of said second input circuit, said control signal connecting to gates of said first and second input circuit P-channel transistors, said inverted control signal connecting to gates of said first and second input circuit N-channel transistors, said N-channel and P-channel transistors of said first and second input circuit having drains connected to said single output.

4. The device of any preceding claim, wherein an AND function of said first input and said control signal is generated at said single output by placing said second input at a low level state.

5. The device of any preceding claim, wherein an OR function of said second input and said control signal is generated at said single output by placing said first input at a high level state.

6. The device of any of claims 1 to 3, wherein an inverted input AND function of said second input and said inverted control signal is generated at said single output by placing said first input at a low level state.

7. The device of any of claims 1 to 3 or claim 6, wherein an inverted input OR function of said first input and said inverted control signal is generated at said single output by placing said second input at a high level state.

8. The device of any preceding claim, wherein connections made between said first input circuit and said second input circuit occur along a single metal track of each of said first and second input circuits.

9. The device of any preceding claim, further comprising a second inverter connected between said first and second inputs such that said second input is an inversion of said first input in order to generate an XOR function of said first input and said control signal at said single output.

10. The device of any of claims 1 to 8, further comprising a second inverter connected between said first and second inputs such that said first input is an inversion of said second input in order to generate an XNOR function of said second input and said control signal at said single output.

11. The base cell device of claim 9 or claim 10, wherein said first inverting circuitry and said second inverting circuitry are disconnected from said first and second input circuitry in order to generate a NAND function of said first and second inputs at said single output.

12. The base cell device of claim 9 or claim 10, wherein said first inverting circuitry and said second inverting circuitry are disconnected from said first and second input circuitry in order to generate a NOR function of said first and second inputs at said single output.

13. The base cell device of claim 9 or claim 10, wherein said second inverting circuitry is disconnected from said first input circuitry and said second input circuitry in order to generate AND, OR, inverted input AND, and inverted input OR functions at said single output.

14. The device of any preceding claim, wherein the first and second input circuits comprise respective first and second transmission gates.

FIG. 1

$O = C \cdot A + \overline{C} \cdot B$

FIG. 2A

$O = \overline{(A \cdot B)}$

FIG. 2B

$O = \overline{(A+B)}$

7

*FIG. 3A*

INPUT A

CONTROL C

30

32

34

VCC

24

26

28

VCC

$\overline{C}$

10

12

16

14

OUTPUT O

22

20

18

$O = C \cdot A + \overline{C} \cdot \overline{A}$

*FIG. 3B*

CONTROL C

30

32

34

VCC

24

26

28

VCC

$\overline{C}$

10

INPUT B

12

16

14

OUTPUT O

22

20

18

$O = C \cdot \overline{B} + \overline{C} \cdot B$

30

VCC      VCC

36        38

32

A
B    MUX 1

40

D
E    MUX 2

42

34

*FIG. 4*

FIG. 5